# EUROPEAN PATENT APPLICATION

(11) **EP 1 928 015 A2**
(43) Date of publication of application: **04.06.2008**
(21) Application number: 07121751.7
(22) Date of filing: 28.11.2007
(51) Int. Cl.: H01L 21/316, H01L 21/312, H01L 21/318

(54) **Organosilane compounds for modifying etch properties of silicon oxide and silicon nitride films**

(30) Priority: 28.11.2006 US 861327 P; 16.11.2007 US 941532
(71) Applicant: Air Products and Chemicals, Inc., Allentown, PA 18195-1501 (US)
(72) Inventor: Xiao, Manchao, San Diego, CA 92130 (US); Thridandam, Hareesh, Vista, CA 92081 (US); Karwacki, Jr. Eugene Joseph, Orefield, PA 18069 (US); Lei, Xinjian, Vista, CA 92081 (US)
(74) Representative: Muir, Benjamin M. J.

(57) **Abstract**

The present invention discloses a process for depositing a carbon containing silicon oxide film, or a carbon containing silicon nitride film having enhanced etch resistance. The process comprises using a silicon containing precursor, a carbon containing precursor and a chemical modifier. The present invention also discloses a process for depositing a silicon oxide film, or silicon nitride film having enhanced etch resistance comprising using an organosilane precursor and a chemical modifier.

## Description

### BACKGROUND OF THE INVENTION

Silicon oxide films are employed for a variety of applications during fabrication of the transistor structure for an integrated circuit. These applications include use as hardmasks for ion implantation, etch stops to control the etching of contact holes, sidewall spacer films along the gate, protective films to shield adjacent materials from damage from etching or cleaning processes, environmental barriers, and dielectric materials to reduce outer fringing capacitance. To address these many needs it is necessary to tailor the chemical and physical properties of these films.

Lower temperature processes for making silicon oxide and silicon nitrides have been developed by using chemical precursors such as hexachlorodisilane (HCDS), bis(tertiarybutyl)silane (BTBAS) and diethylsilane (LTO-410). However, there is very little process flexibility available for altering the properties, such as dielectric constant, density, wet etch rate of films made from these chemistries.

US Patent Application 2006/0228903 A1 teaches the use of combing two precursor chemistries to fabricate a carbon doped silicon nitride film. Precursor 1 is used to create the film structure and precursor 2 is utilized to add carbon to the film. Included in the disclosure are structure forming precursors such as BTBAS, dichlorosilane (DCS), HCDS, as well as other aminosilanes. A number of alkylsilane precursors are identified for use as carbon doping precursors. These include methylsilane (1 MS), dimethylsilane (2MS), trimethylsilane (3MS), and tetramethylsilane (4MS). In addition, other families of precursors identified include alkyldisilanes and halogen containing alkylsilanes. Though the patent application identifies a variety of potential additives there is no experimental data to verify the feasibility of the approach. For example, it is known that the bond dissociation energies for some alkyl groups attached to silicon are very weak, and, therefore, will not be able to be incorporated into the film being deposited.

US Patent Application 2005/0236694 A1 teaches the deposition of a carbon etch stop (CES) film using 3MS and 4MS by Plasma Enhanced Chemical Vapor Deposition (PECVD). By this process carbon doped silicon oxides and carbon doped silicon nitrides can be deposited with varying dielectric constants at temperatures below 500°C. PECVD is a very enabling process for depositing lower temperature materials with varying properties. However, it is not a highly favored process for depositing films in close proximity to transistors.

US Patent 2005/0255714 A1 teaches the use of amino disilanes, silyl azides, and silyl hydrazines for depositing silicon nitrides and silicon oxides by Low Pressure Chemical Vapor Deposition (LPCVD). Though the application proposes the feasibility of these precursors there is no experimental data presented that supports films can be made from these precursors in a manner that addresses the cost-of-ownership needed to be utilized in the manufacture of integrated circuits. Furthermore, there may be issues related to the safe handling and use of the materials.

### BRIEF SUMMARY OF THE INVENTION

One embodiment of the present invention is a process for depositing a carbon containing silicon oxide film or a carbon containing silicon nitride film having enhanced etch resistance comprising:
providing a structure precursor containing silicon;
providing a dopant precursor containing carbon;
mixing the dopant precursor containing carbon with the structure precursor containing silicon to obtain a mixture having a mixing ratio of Rm (% weight of the dopant precursor containing carbon added to the structure precursor containing silicon) between 2% and 85%; and a flow rate of Fm;
providing a chemical modifier having a flow rate of Fc;
having a flow ratio R2 defined as R2=Fm/Fc between 25% and 75%; and
producing the carbon containing silicon oxide film or the carbon containing silicon nitride film having enhanced etch resistance wherein the etch resistance is increased with increasing incorporation of the carbon.

To increase the incorporation of the carbon, the mixing ratio Rm is increased. The etch resistance is increased by increasing the mixing ratio Rm. The etch resistance is further increased by increasing the flow ratio R2. The deposition rate is increased by increasing the mixing ratio Rm, and further increased by increasing the flow ratio R2. The film density is decreased by increasing the mixing ratio Rm, and further decreased by increasing the flow ratio R2. These parameters may, for example, be increased relative to the parameters used in producing a previous silicon oxide or nitride film, or relative to the parameters initially used in producing the silicon oxide or nitride film currently being produced.

The process of the depositing is performed at a temperature between 350° C and 700° C and at a pressure between 0.2 torr and 10 torr (25 to 1350 Pa).

The process of the depositing is selected from Atomic Layer Deposition (ALD), Chemical Vapor Deposition (CVD), Low Pressure Chemical Vapor Deposition (LPCVD), Plasma Enhanced Chemical Vapor Deposition (PECVD), and Remote Downstream Processes.

The chemical modifier is selected from oxygen, nitrogen, ammonia, helium, argon, xenon, hydrogen and mixtures thereof. The structure precursor containing silicon is selected from bis(tertiarybutyl)silane, tetraethylorthosilcate, dichlorosilane, hexachlorodisilane and mixtures thereof. The dopant precursor is selected from methyl silane, dimethylsilane, trimethylsilane, tetramethyl silane, tetravinyl silane, phenylsilane, cyclohexylsilane and mixtures thereof.

Another embodiment of the present invention is a Low Pressure Chemical Vapor Deposition (LPCVD) process for depositing a carbon containing silicon oxide film or a carbon containing silicon nitride film having enhanced etch resistance comprising:
providing a bis(tertiarybutyl)silane precursor;
providing a phenylsilane precursor;
mixing the phenylsilane precursor with the bis(tertiarybutyl)silane precursor to obtain a mixture having a mixing ratio of Rm (% weight of the phenylsilane precursor added to the bis(tertiarybutyl)silane precursor) between 2% and 85% and a flow rate of Fm;
providing a chemical modifier selected from oxygen, nitrogen, ammonia and mixtures thereof; and having a flow a rate of Fc;
having a flow ratio R2 defined as R2=Fm/Fc between 25% and 75%; and
producing the carbon containing silicon oxide film or the carbon containing silicon nitride film having enhanced etch resistance wherein the etch resistance is increased with increasing incorporation of the carbon.

To increase the incorporation of the carbon, the mixing ratio Rm is increased. The etch resistance is increased by increasing the mixing ratio Rm. The etch resistance is further increased by increasing the flow ratio R2. The deposition rate is increased by increasing the mixing ratio Rm, and further increased by increasing the flow ratio R2. The film density is decreased by increasing the mixing ratio Rm, and further decreased by increasing the flow ratio R2.

The process of the depositing is performed at a temperature between 350° C and 700° C and at a pressure between 0.2 torr and 10 torr (25 to 1350 Pa).

Yet another embodiment of the present invention is a Low Pressure Chemical Vapor Deposition (LPCVD) process for depositing a silicon oxide or a silicon nitride film having enhanced etch resistance comprising:
providing an organosilane precursor selected from tetravinyl silane,
phenylsilane, cyclohexylsilane and mixtures thereof; and having a flow rate of Fs;
providing a chemical modifier selected from oxygen, nitrogen, ammonia and mixtures thereof; and having a flow rate of Fc;
having a flow ratio R1 defined as R1=Fs/Fc between 25% and 75%; and
producing the silicon oxide film or the silicon nitride film having increased etch resistance.

The process of the depositing is performed at a temperature between 350° C and 700° C and at a pressure between 0.2 torr and 10 torr (25 to 1350 Pa). The etch resistance is increased by increasing the flow ratio R1.

### BRIEF DESCRIPTION OF SEVERAL VIEWS OF THE DRAWINGS

**Figure 1** shows the 1% HF Wet Etch Rate and the Density of a carbon containing silicon oxide film as the function of the precursor mixing ratio.
**Figure 2** shows the 1% HF Wet Etch Rate and the Density of a carbon containing silicon oxide film as the function of the atomic fraction carbon detected in the film.
**Figure 3** shows the FT-IR spectrum obtained from a SiO₂ film deposited from a blend of 75% BTBAS and 25% phenylsilane.
**Figure 4** shows the Carbon 1s XPS spectrum obtained from a film deposited using 50% BTBAS and 50% Phenylsilane.
**Figure 5** shows the FT-IR spectrum for a silicon nitride film deposited using a blend of 75% BTBAS and 25% Phenylsilane.
**Figure 6** shows the 1% HF Wet Etch Rate and the Density of a carbon containing silicon nitride film as the function of the precursor mixing ratio.
**Figure 7** shows the 1% HF Wet Etch Rate and the Density of a carbon containing silicon nitride film as the function of the atomic fraction carbon detected in the film.

### DETAILED DESCRIPTION OF THE INVENTION

Applications are emerging for silicon oxide and silicon nitride films in the front-end-of-line manufacturing of logic and memory devices. The applications range from their use as sacrificial films, hardmasks, sidewall spacers, and environmental barriers. These uses require changes to the chemical and physical properties of these films. These include reducing the wet etch rate, increasing the wet etch rate, modifying the dielectric constant, and altering film stress. Two routes have been explored for addressing these multiple film needs: use of a novel structure forming precursor chemistry that enables the deposition of a modified silicon oxide or nitride, and combination of a structure forming precursor already used for depositing such films with an additive chemistry that facilitates changes to the base film characteristics of the structure forming precursor. The advantage of the second approach is that more tuning flexibility is possible, because chemistry and process conditions can both be employed to alter the properties of a dielectric film.

The chemistries in this invention enable the deposition of silicon oxide and silicon nitride films with differing performance properties than those obtained by the aforementioned chemistries. Furthermore, by combining these chemistries with the aforementioned chemical precursors it is possible to modify the physical and chemical properties of dielectric films made from these structure forming precursors. A family of organosilane precursors have been identified that enable both of these approaches.

This invention utilizes two approaches for making dielectric films of silicon oxide, silicon nitride, and silicon carbide.

The first approach employs an organosilane based precursor, in combination with a chemical modifier, for example, an oxygen source for making SiO₂, a nitrogen source for making Si₃N₄, and an inert gas such as helium for making SiC. This approach is shown in Equations (1), (2), and (3).

Organosilane Precursor + O₂ + Carrier Gas (optional) → Modified SiO₂ (1)

Organosilane Precursor + NH₃ + Carrier Gas (optional) → Modified SiN (2)

Organosilane Precursor + Inert Gas + Carrier Gas (optional) →Modified SiC (3)

Though Low Pressure Chemical Vapor Deposition (LPCVD) is employed for the examples cited in this application, it is also possible to employ these organosilane precursors using Plasma Enhanced Chemical Vapor Deposition (PECVD), Atomic Layer Deposition (ALD), and Remote Downstream Processes to deposits these dielectric films.

Modified SiO₂, SiN and SiC films are defined as films that possess a morphological structure similar to a pure film of each material, but whose overall chemical composition has been altered by the presence of additional carbon and/or nitrogen in the final film. The presence of these species alter the refractive index, and density of the resulting film. These changes lead to films with a dielectric constant that is either higher or lower than the unmodified SiO₂ and Si₃N₄. These changes can also lead to changes in performance properties such as wet etching rates in acids solutions containing HF(hydrofluoric acid) or H₃PO₄.

Without being bound by theory those organosilane precursors that work best for these applications are ones in which there are either very strong Si-C bonds present, such as in Phenylsilane (Calculated Bond Dissociation Energy [BDE] = 89 Kcal/mole), or multiple Si-C bonds, such as tetravinylsilane, are present to assure Si-C bonds are incorporated into the film structure.

Another approach for making modified SiO₂ and SiN films is to utilize a structure forming precursor containing silicon to create the required base film, while doping with a second dopant precursor that enables the desired change in film properties, and a chemical modifier.

For example, BTBAS, HCDS, and DCS are well known structure precursors containing silicon for making silicon oxide and silicon nitride films. Because of the chemical structure of these precursors, the process windows utilized are such that the resulting film will have a refractive index, dielectric constant, and wet etch rate within a narrow range of values. Altering the process conditions such as temperature, pressure, flow rate of precursor and additives (i.e., O₂, N₂, and inert gas) will typically not create a film with properties far from the film deposited under optimum process conditions.

To alter the properties of the film made from one of these precursors, our approach is to "dope" or add a second dopant precursor (containing carbon) to the process. For example, a second organosilane precursor such as phenylsilane can be utilized as a dopant to the standard process used to make SiO₂ from BTBAS. Equations (4) and (5) illustrate this process approach.

Structure Precursor + Organosilane + O₂ + Carrier Gas (Optional) → Modified SiO₂ (4)

Structure Precursor + Organosilane + NH₃ + Carrier Gas (Optional) → Modified SiN (5)

An advantage of the use of a second dopant precursor for incorporating carbon into the final film is that the carbon is networked via chemical bonds into the film as it forms on the substrate. Oftentimes it is difficult to dope small amounts of carbon into a thin film via the addition of small hydrocarbon molecules such as acetylene, ethylene, ethane, propylene, etc., because a hot surface (typically above 400°C) will not facilitate the condensation of small carbon molecules onto the surface. Furthermore, if the carbon is "free" within the film as it forms there is also the chance for carbon migration to occur either towards the surface of the film or towards the underlying substrate interface.

This effect can also occur if the bond between the carbon that tethers it to another functionality such as a silicon or nitrogen atom is weak. As the molecule condenses onto a surface during film formation the carbon functionality will break free and be able to migrate. For example in BTBAS the tertiary butyl groups attached to nitrogen are quite thermally labile. Bond Dissociation Energy (BDE) calculations estimate the bond strength for the bond between Nitrogen and the t-butyl group to be 75.1 Kcal/mole. This is one of the weakest bonds present within BTBAS. Thus, it is expected to be one of the first to break in a thermal CVD process. There is an alternative benefit, however, to this bond breakage in that the free carbon can then migrate to the substrate interface and act as a barrier to the diffusion of implant dopants.

By networking the carbon into the structure of the film the carbon is more uniformly dispersed throughout the dielectric thin film. This dispersion will help enable a more uniformed wet etching rate for the film, and lower of the overall density of the film.

### Working Examples

The following examples are provided for the purpose of further illustrating the present invention but are by no means intended to limit the same.

Example 1 is the standard process for making a SiO₂ from BTBAS using a LPCVD process. This example is performed as a baseline for the other data.

Examples 2- 5 are supporting data for the first approach in the present invention of making modified silicon oxides through an organosilane containing precursor in combination with an oxygen source.

Examples 6-9 are supporting data for the second approach in the present invention of modifying silicon oxides or silicon nitrides through carbon doping. More specifically, a process to deposit modified silicon oxides or silicon nitrides of using an existing precursor chemistry such as BTBAS doped with organosilane (containing carbon), such as phenylsilane. The advantage of this approach is that the film is derived from a chemistry already in use. Thus, there are fewer installation and process issues to be addressed than if an entirely new chemistry was being implemented. Furthermore, by changing the ratio of the two chemistries present with the formulation it is possible to further tune the final film properties to suit the process need.

### Example 1: Baseline Process - Deposition of Silicon Oxide from BTBAS

This is the standard process for making a SiO₂ from BTBAS using a LPCVD process. The process conditions for this example were:
LPCVD Deposition, temperature was at 550°C, pressure was at 250 mtorr (33 Pa), flow ratio of O₂:Precursor (BTBAS) was 2:1. The results were shown in Table 1.

**Table 1**

| **Refractive Index** | **Dielectric Constant** | **1% HF Wet Etch Rate (Å/sec)** |
|---|---|---|
| 1.499 | 6.1 | 3.0 |

### Example 2: Deposition of Silicon Oxide from Phenylsilane

The process conditions for this example were:
LPCVD Deposition, temperature range was from 400°C to 500°C, pressure was at 600 mtorr (80 Pa), flow ratio of Precursor(Phenylsilane):O₂ was from 2:1 to 4:1. The results were shown in Table 2.

**Table 2**

| **Deposition Temp. (°C)** | **Precursor: O2** | **Refractive Index** | **Dielectric Constant** | **1% Wet Etch Rate** |
|---|---|---|---|---|
| 400 | 3:1 | 1.5311 | Not Measured | 0.10 |
| 450 | 4:1 | 1.5163 | 3.81 | 0.16 |
| 500 | 2:1 | 1.5117 | 4.12 | 0.56 |

### Example 3: Deposition of Silicon Oxide from Tetravinylsilane

The process conditions for this example were:
LPCVD deposition, temperature range was from 500°C to 600°C, pressure range was from 600 mtorr to 1 Torr (80 to 133 Pa) pressure, flow ratio of Precursor(Tetravinylsilane) : O₂ was from 1:1 to 1:2. The results were shown in Table 3.

**TABLE 3**

| **Deposition Temp. (°C)** | **Precursor :O2** | **Pressure (Torr (Pa))** | **Refractive Index** | **Dielectric Constant** | **1% Wet Etch Rate** |
|---|---|---|---|---|---|
| 500 | 1:1 | 0.6(80) | 1.2634 | 5.26 | 0(ND) |
| 500 | 1:2 | 0.6 (80) | 1.3370 | 4.33 | 0.05 |
| 500 | 2:1 | 1 (133) | 1.4281 | 4.2 | 0.07 |
| 600 | 2:1 | 1 (133) | 1.5133 | 4.63 | 0.07 |

| | | | | | |
|---|---|---|---|---|---|
| ND: no etch rate detected, assumed to be 0 Å/sec | | | | | |

### Example 4: Deposition of Silicon Oxide from Cyclohexylsilane

The process conditions for this example were:
LPCVD deposition, temperature range was from 500°C to 600°C, pressure was at 600 mtorr (80 pa), flow ratio of Precursor(Cyclohexylsilane) : O₂ was from 1.3 :1 to 2.5 :1. The results were shown in Table 4.

**TABLE 4**

| **Deposition Temp. (°C)** | **Precursor :O2** | **Refractive Index** | **Dielectric Constant** | **1% Wet Etch Rate** |
|---|---|---|---|---|
| 500 | 1.3:1 | 1.3694 | 5.65 | Not Measured |
| 500 | 1.3:1 | 1.4418 | 5.25 | 1.06 |
| 500 | 2.5:1 | 1.4546 | 4.98 | 0.81 |
| 600 | 2.5:1 | 1.5559 | 4.45 | 0.3 |

### Example 5: Deposition of Silicon Oxide from Tertbutylsilane

The process conditions for this example were:
LPCVD deposition, temperature range was from 450°C to 500°C, pressure was at 600 mtorr (80 Pa), flow ratio of Precursor (Tertbutylsilane) :O₂ was at 1.7:1.

**TABLE 5**

| **Deposition Temp. (°C)** | **Precursor :O2** | **Refractive Index** | **Dielectric Constant** | **1% Wet Etch Rate** |
|---|---|---|---|---|
| 450 | 1.7:1 | 1.4158 | 5.56 | 1.55 |
| 500 | 1.7:1 | 1.4158 | 5.56 | 1.46 |

Examples 2 to 5 have shown that silicon oxide films that etches slower (indicated by lower wet etch rate) than a BTBAS-derived film have been deposited. This was achieved by increasing the flow ratio (the flow rate of the precursor relative to the flow rate of the O₂) and increasing the process temperature in the process. More specifically, keeping the other conditions unchanged, when the flow ratio increased, and/or when the process temperature increased, the wet etch rate decreased, thus the etch resistance was increased in the process.

### Example 6: Deposition of Carbon Containing Silicon Oxide from BTBAS and Phenylsilane

This example employs BTBAS as the primary structure forming precursor and phenylsilane as the dopant precursor to modify the material properties. The two chemicals were premixed by adding phenylsilane to BTBAS by weight. The mixing ratio was between 0% to 75%.

The process conditions for this example were:
LPCVD deposition, temperature was at 550°C, pressure was at 250 mTorr (33 Pa), Precursor mixture (BTBAS and Phenylsilane) flow was at 14 sccm, O₂ Flow was at 5 sccm, and Helium sweep was at 10 sccm. Table 6 summarizes the film composition and wet etch performance rate data.

**Table 6**

| **Wt.%Phenylsilane Added** | **Average Refractive Index** | **Density (XRR) (grams/cm³**) | **1% HF Wet Etch Rate (Å/sec)** | **Composition [Auger Analysis] (% Atomic)** | |
|---|---|---|---|---|---|
| 0 | 1.499 | 2.28 | 2.99 | Si = 40.5 | O = 57 |
| | | | | N=2.5 | C=0 |
| 25 | 1.5690 | 2.06 | 0.27 | Si = 36 | O = 45.5 |
| | | | | N = 4.0 | C = 14.5 |
| 50 | 1.554 | 1.92 | 0.15 | Si = 34 | O = 42 |
| | | | | N=3 | C = 21 |
| 75 | 1.5820 | 1.81 | 0 | Si = 29 | O = 33 |
| | | | | N=2.5 | C=35.5 |

The results showed that higher additions of phenylsilane to BTBAS (higher mixing ratio) lead to a lowering of the resultant density of the oxide film, and at the same time a decrease in the HF wet etch rate of the film thus an increase of the etch resistance. Most importantly, this study illustrated the potential of phenylsilane as a means for facilitating carbon incorporation into the oxide film. Higher amounts of phenylsilane in the formulation lead to larger amounts of carbon incorporated into the film structure. Thus, by manipulating the concentration of phenylsilane in the formulation with BTBAS it should be possible to gain additional process control over the resulting concentration of carbon present within an oxide film deposited from this formulation.

To validate this, a follow-up study was performed, in which smaller concentrations of Phenylsilane was added to BTBAS, and silicon oxide films were then deposited from the resulting blends.

The same process temperature and pressure conditions as noted above were again utilized for this study. Precursor mixture (BTBAS and Phenylsilane flow) was at 14 sccm, O₂ Flow was at 20 sccm, Helium flow was held at 10 sccm.

Table 7 summarizes the process data, and table 8 summarizes the composition and film performance data .

**Table 7**

| **Wt.% Phenylsilane Added** | **Deposition Rate (Å/min)** | **Film Thickness (Å)** | **Wafer-in-Wafer Uniformity (%)** | **Wafer-to-Wafer Uniformity (%)** |
|---|---|---|---|---|
| 0 | 20.6 | 826 | 2.2 | 0.8 |
| 2 | 21.4 | 857 | 1.4 | 0.8 |
| 5 | 23.0 | 920 | 2.7 | 0.6 |
| 10 | 25.1 | 1004 | 1.9 | 0.9 |
| 25 | 32.6 | 1305 | 3.0 | 2.6 |

**Table 8**

| **Wt.% Phenylsilane Added** | **Average Refractive Index** | **Density (XRR) (grams/cm³)** | **1% HF Wet Etch Rate (Å/sec)** | **10% HF Wet Etch Rate (Å/sec)** | **Composition [RBS/HFS] (% Atomic)** | |
|---|---|---|---|---|---|---|
| 0 | 1.5089 | 2.18 | 2.68 | > 60 | Si = 26 | O = 52 |
| | | | | | N=6 | C = 3 |
| | | | | | H=13 | |
| 2 | 1.5104 | 2.17 | 2.27 | 60 | Si = 29 | O = 57 |
| | | | | | N=7 | C = 3 |
| | | | | | H=4 | |
| 5 | 1.5065 | 2.15 | 1.67 | 33 | Si = 24 | O = 49 |
| | | | | | N=5 | C=7 |
| | | | | | H=15 | |
| 10 | 1.5197 | 2.11 | 1.28 | 23 | Si = 22 | O = 45 |
| | | | | | N=4 | C = 7 |
| | | | | | H=22 | |
| 25 | 1.5253 | 2.01 | 0.73 | 13 | Si = 23 | O=46 |
| | | | | | N=3 | C=10 |
| | | | | | H=18 | |

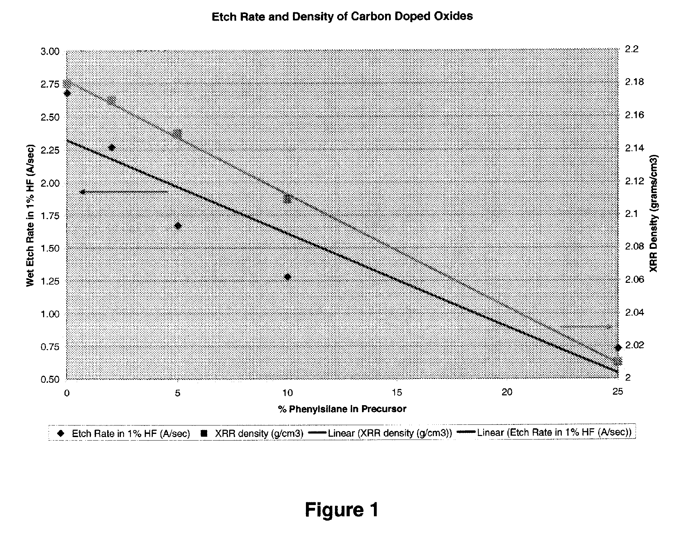

Figure 1 shows 1% HF Wet Etch Rate and Density as the function of the precursor mixing ratio. The 1% HF Wet Etch Rate and the Density decreased as the mixing ratio increased, that is, when the mixture contains relative more phenylsilane.

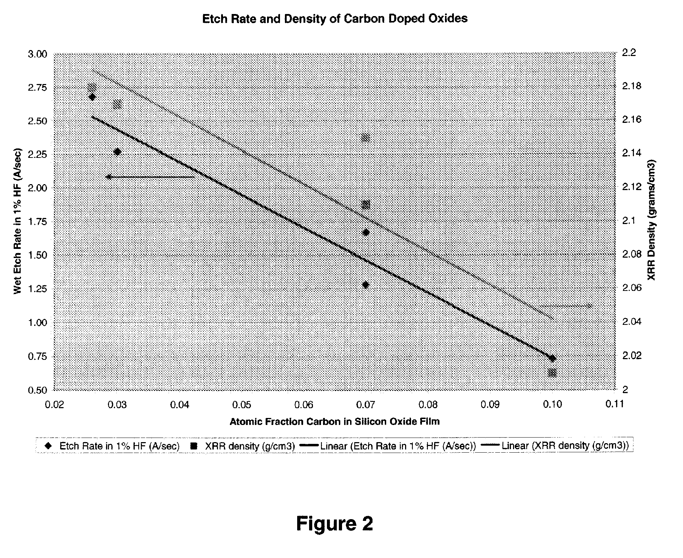

Figure 2 has shows 1% HF Wet Etch Rate and Density as the function of the atomic fraction carbon detected in the film. The 1% HF Wet Etch Rate and the Density decreased as more atomic fraction carbon were incorporated into the structure of the silicon oxide film. Therefore, the etch resistance was enhanced by incorporating the carbon into the film structure.

The results have shown that by adding up to 25% phenylsilane to the precursor formulation, the wet etching rate for the deposited film was substantially lowered. A surprising finding from this study was that as these changes occurred, at the same time the overall density of the film decreased by about 10%. Typically, lower HF wet etching rates are indicative of more dense films. Current compositional analysis showed that in going from 100% BTBAS to a formulation containing 75% BTBAS and 25% Phenylsilane, the concentration of carbon was increased from 3% to 10 % by atomic weight. Not being bound by theory it is believed that the added carbon present within the film is what is helping to lower the wet etching rate of the films.

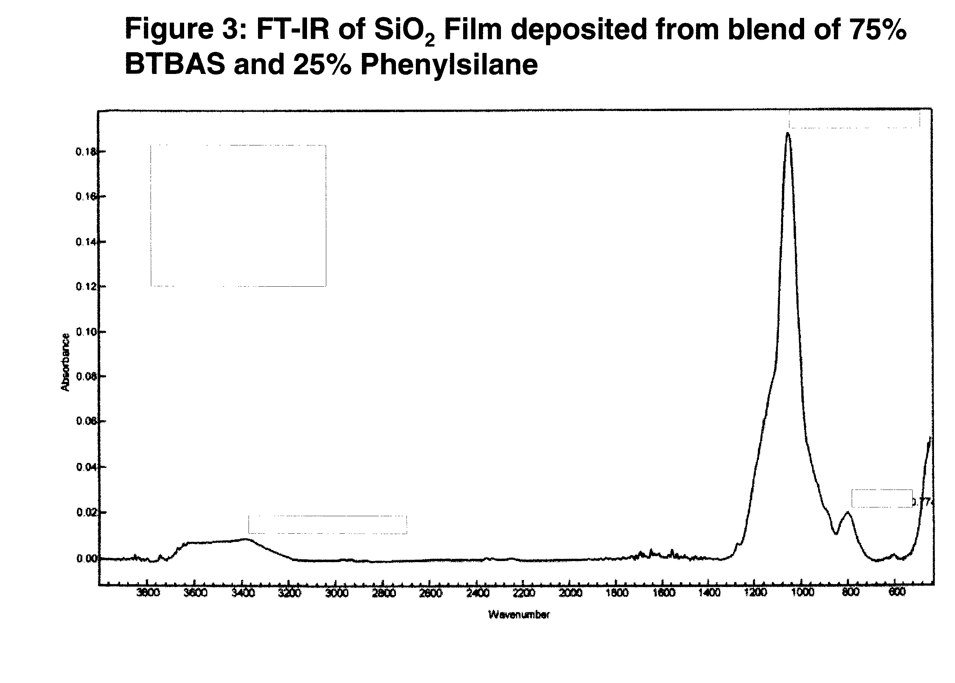

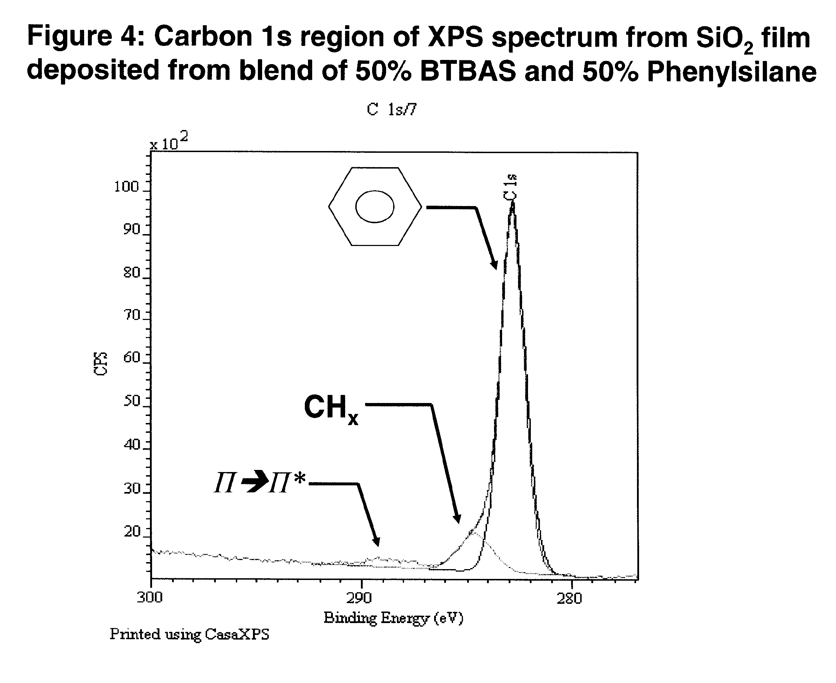

Figure 3 shows the FT-IR spectrum obtained from a SiO₂ deposited from a blend of 75% BTBAS and 25% phenylsilane. The spectrum showed a strong Si-O stretch absorbance at 1080 cm⁻¹ with a shoulder of Si-C band at 1100 cm⁻¹ which confirms that the film is SiO₂ with some carbon incorporated. It is interesting to note that there appears to be very little Si-H present within the spectrum even though there is 18% hydrogen measured by Forward Scatterings within the film. We believe the hydrogen is primarily bound to the phenyl group rather than within the SiO₂ network. The Carbon 1s XPS spectrum obtained from a film deposited using 50% BTBAS and 50% Phenylsilane shown in Figure 4 confirmed the presence of intact phenyl groups within the film. Here the Π to Π* shake-up feature located near 288.5 eV is a very good indicator of the presence of an aromatic hydrocarbon structure.

### Example 7: Deposition of Carbon Containing Silicon Nitride from BTBAS and Phenylsilane

This same process of carbon doping using an organosilane precursor can be employed to also deposit a carbon doped silicon nitride film.

The process conditions for this example were:
LPCVD deposition, temperature was at 570°C, pressure was at 250 mTorr (33 Pa), the precursor mixture of BTBAS and Phenylsilane flow was at 9sccm, NH₃ Flow was at 40 sccm, the flow ratio of NH₃: Precursor Blend was 0.225, and Helium sweep was at 10 sccm.

Table 9 summarizes the process data, and Table 10 summarizes the composition and film performance data.

**Table 9**

| **Wt.% Phenylsilane Added** | **Deposition Rate (Å/min)** | **Film Thickness (Å)** | **Wafer-in-Wafer Uniformity (%)** | **Wafer-to-Wafer Uniformity (%)** |
|---|---|---|---|---|
| 0 | 5.7 | 345 | 4.4 | 3.0 |
| 2 | 6.2 | 370 | 5.3 | 2.0 |
| 5 | 6.1 | 369 | 4.7 | 1.7 |
| 10 | 6.8 | 406 | 5.0 | 1.9 |
| 25 | 8.9 | 535 | 5.7 | 1.4 |

**Table 10**

| **Wt.% Phenylsilane Added** | **Average Refractive Index** | **Density (XRR) (grams/cm³)** | **1% HF Wet Etch Rate (Å/sec)** | **10% HF Wet Etch Rate (Å/sec)** | **Composition [RBS/HFS] (% Atomic)** | |
|---|---|---|---|---|---|---|
| 0 | 1.8788 | 2.40 | 0.07 | 1.05 | Si = 42 | O = 5 |
| | | | | | N = 42 | C = 7 |
| | | | | | H=4 | |
| 2 | 1.8546 | 2.37 | 0.07 | 0.80 | Si = 35 | O = 4 |
| | | | | | N=35 | C=8 |
| | | | | | H=18 | |
| 5 | 1.8539 | 2.26 | 0.05 | 0.5 | Si = 30 | O = 2 |
| | | | | | N=30 | C=15 |
| | | | | | H=23 | |
| 10 | 1.8379 | 2.17 | 0.03 | 0.25 | Si = 28 | O = 3 |
| | | | | | N=28 | C= 17 |
| | | | | | H=24 | |
| 25 | 1.8277 | 2.05 | 0.02 | 0.10 | Si = 21 | O=7 |
| | | | | | N= 17 | C=23 |
| | | | | | H=32 | |

As for carbon doped silicon oxides, we observed that the inclusion of carbon via this methodology can be controlled over a wide range of conditions. As the amount of phenylsilane was increased from 0% to 25% we observe a 15% decrease in the density of the silicon nitride film. Concurrently, there was a significant decrease in the HF wet etch rate of the film. Typically, a lower wet etch rate is attributed to a denser silicon nitride film.

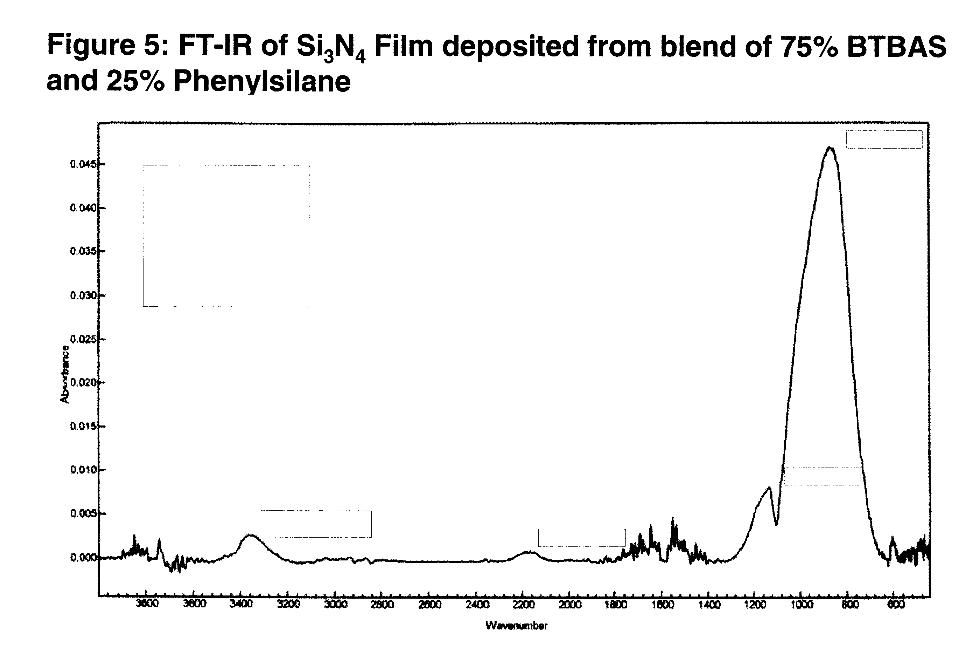

Figure 5 shows the FT-IR spectrum for a silicon nitride film deposited using a blend of 75% BTBAS and 25% Phenylsilane. The figure showed a strong Si-N stretch absorbance at 870 cm⁻¹ with a shoulder of Si-C band at 1100 cm⁻¹, which confirmed that the film is a silicon nitride film with some carbon incorporated.

### Example 9: Deposition of Silicon Nitride from BTBAS and Phenylsilane:

### Higher Precursor Mixture to ammonia (NH₃) Flow

Films of silicon nitride were deposited from blends of BTBAS and Phenylsilane. The precursor mixture of BTBAS and Phenylsilane flow was at 14cm, NH₃ Flow was at 20sccm. The ratio of precursor mixture flow to ammonia flow was increased from 0.225 in Example 8 to 0.7 in this example. Other process conditions for this example are the same as in example 8. In addition, two additional Phenylsilane doping concentrations were added in between 10% and 25%, for comparison with the values shown in the previous example.

Table 11 summarizes the process data, and Table 12 summarizes the composition and film performance data.

**Table 11**

| **Wt.% Phenylsilane Added** | **Deposition Rate (Å/min)** | **Film Thickness (Å)** | **Wafer-In-Wafer Uniformity (%)** | **Wafer-To-Wafer Uniformity (%)** |
|---|---|---|---|---|
| 0 | 10.1 | 932 | 7.6 | 1.8 |
| 2 | 11.9 | 1034 | 16.6 | 1.7 |
| 5 | 11.8 | 959 | 6.6 | 3.2 |
| 10 | 13.5 | 1203 | 11.1 | 3.3 |
| 15 | 14.4 | 1067 | 7.2 | 2.1 |
| 20 | 16.5 | 1185 | 13.0 | 1.6 |
| 25 | 17.3 | 1043 | 9.34 | 0.5 |

**Table 12**

| **Wt.% Phenylsilane Added** | **Average Refractive Index** | **Density (XRR) (grams/cm³)** | **1% HF Wet Etch Rate (Å/sec)** | **10% HF Wet Etch Rate (Å/sec)** | **Composition [RBS/HFS] (% Atomic)** | |
|---|---|---|---|---|---|---|
| 0 | 1.8496 | 2.19 | 0.4 | 1.08 | Si = 37 | O = 1 |
| | | | | | N=37 | C=8 |
| | | | | | H=17 | |
| 2 | 1.8485 | 2.18 | 0.095 | 0.97 | Si = 34 | O = 1 |
| | | | | | N=33 | C=9 |
| | | | | | H=23 | |
| 5 | 1.8321 | 2.17 | 0.08 | 0.93 | Si = 29 | O = 5 |
| | | | | | N=29 | C = 12 |
| | | | | | H=25 | |
| 10 | 1.8264 | 2.17 | 0.06 | 0.88 | Si = 25 | O = 8 |
| | | | | | N=25 | C = 14 |
| | | | | | H=28 | |
| 15 | 1.8214 | 2.06 | 0.03 | 0.51 | Si = 20 | O = 8 |
| | | | | | N=20 | C = 18 |
| | | | | | H=33 | |
| 20 | 1.8239 | 2.01 | 0.02 | 0.32 | Si = 22 | O = 8 |
| | | | | | N = 21 | C = 24 |
| | | | | | H=25 | |
| 25 | 1.8100 | 1.94 | 0.03 | 0.24 | Si = 19 | O = 6 |
| | | | | | N=21 | C=21 |
| | | | | | H=33 | |

The higher precursor mixture to ammonia flow ratio resulted in almost a doubling of the film deposition rate. The refractive index for the higher precursor flow conditions were lower than those observed for the lower precursor flow condition. This would indicate it was possible to lower the dielectric constant of carbon doped silicon nitride films using a combination of chemical and process control variable.

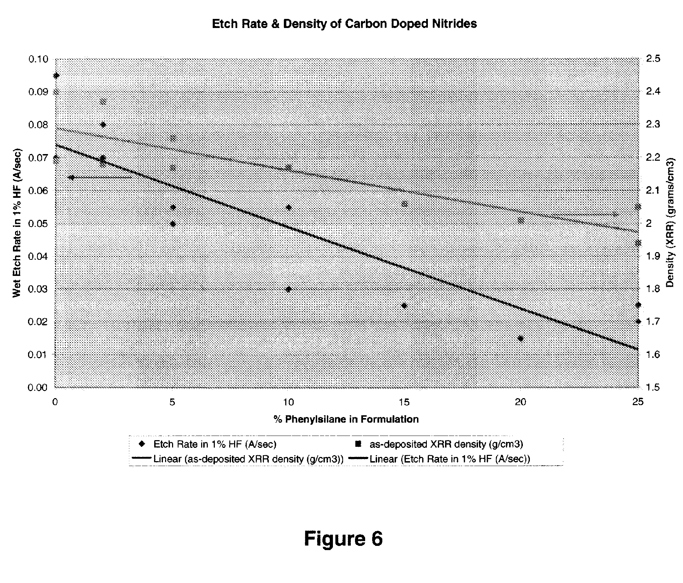

Figure 6 shows the 1% HF Wet Etch Rate and the Density as the function of the precursor mixing ratio. Data from Tables 9-12 were all plotted in the figure. The 1% HF Wet Etch Rate and the Density are decreased as the mixing ratio is increased, that is, the mixture contains relative more phenylsilane.

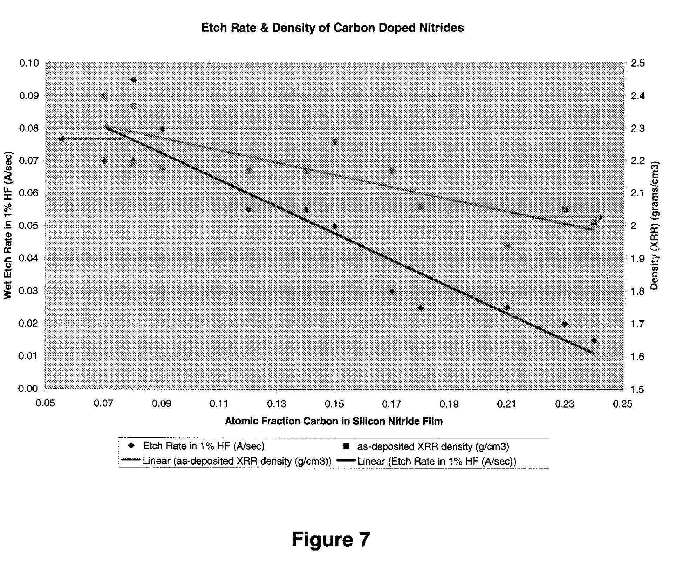

Figure 7 shows the 1% HF Wet Etch Rate and the Density as the function of the atomic fraction carbon detected in the film. The data was from Tables 9-12. The 1% HF Wet Etch Rate and the Density decreased as more atomic fraction carbon were incorporated into the structure of the silicon nitride film.

Examples 6 to 9 have shown that by adding between 2% and 75% phenylsilane to the base BTBAS deposition process we were able to increase the deposition rate, reduce the density of the film, and reduce the wet etch rate of the film. The surprising observations of lower density, and lower wet etching rate is believed due to the presence of between 1 % and 35% by atomic weight of carbon within the deposited film. Thus, those carbon doped silicon oxide and carbon doped silicon nitride films can be used as an etch stop barrier for wet etch processes.

The foregoing examples and description of the embodiments should be taken as illustrating, rather than as limiting the present invention as defined by the claims. As will be readily appreciated, numerous variations and combinations of the features set forth above can be utilized without departing from the present invention as set forth in the claims.

## Claims

1. A process for depositing a carbon containing silicon oxide film or a carbon containing silicon nitride film having enhanced etch resistance comprising:
mixing a dopant precursor containing carbon with a structure precursor containing silicon to obtain a mixture having a mixing ratio Rm of between 2% and 85%, wherein Rm=(the weight of added dopant precursor/the total weight of the mixture)x100%;
providing said mixture at a flow rate of Fm and providing a chemical modifier at a flow rate of Fc, the flow ratio R2, defined as R2=(Fm/Fc)x100%, being between 25% and 75%; and
producing the carbon containing silicon oxide film or the carbon containing silicon nitride film.

2. The process of Claim 1 wherein the chemical modifier is selected from oxygen, nitrogen, ammonia, helium, argon, xenon, hydrogen and mixtures thereof.

3. The process of any preceding claim wherein the structure precursor containing silicon is selected from bis(tertiarybutyl)silane, tetraethylorthosilcate, dichlorosilane, hexachlorodisilane, and mixtures thereof.

4. The process of any preceding claim wherein the dopant precursor containing carbon is selected from methyl silane, dimethylsilane, trimethylsilane, tetramethyl silane, tetravinyl silane, phenylsilane, cyclohexylsilane, and mixtures thereof.

5. The process of any preceding claim wherein the carbon containing silicon oxide or silicon nitride film is deposited by Atomic Layer Deposition, Chemical Vapor Deposition, Low Pressure Chemical Vapor Deposition, Plasma Enhanced Chemical Vapor Deposition, or Remote Downstream Processes.

6. The process of Claim 1, wherein the carbon containing silicon oxide or silicon nitride film is produced by Low Pressure Chemical Vapor Deposition, the structure precursor is a bis(tertiarybutyl)silane precursor, the dopant precursor is a phenylsilane precursor, and the chemical modifier is selected from oxygen, nitrogen, ammonia and mixtures thereof.

7. The process of any preceding claim, comprising increasing the mixing ratio Rm to increase the etch resistance.

8. The process of any preceding claim, comprising increasing the mixing ratio Rm to increase deposition rate.

9. The process of any preceding claim, comprising increasing the mixing ratio Rm to decrease film density.

10. The process of any preceding claim, comprising increasing the flow ratio R2 to increase the etch resistance.

11. The process of any preceding claim, comprising increasing the flow ratio R2 to increase deposition rate.

12. The process of any preceding claim, comprising increasing the flow ratio R2 to decrease film density.

13. A Low Pressure Chemical Vapor Deposition process for depositing a silicon oxide or a silicon nitride film having enhanced etch resistance comprising:
providing an organosilane precursor, selected from tetravinyl silane, phenylsilane, cyclohexylsilane and mixtures thereof, at a flow rate of Fs;
providing a chemical modifier, selected from oxygen, nitrogen, ammonia and mixtures thereof, at a flow rate of Fc, wherein the flow ratio R1, defined as R1=(Fs/Fc)x100%, is between 25% and 75%; and
producing the silicon oxide film or the silicon nitride film.

14. The process of Claim 13, comprising increasing the flow ratio R1 to increase etch resistance.

15. The process of any preceding claim, comprising increasing the temperature at which the silicon oxide or silicon nitride film is produced to increase etch resistance.

16. The process of any preceding claim, wherein the silicon oxide or silicon nitride film is produced at a temperature between 350° C and 700° C, and at a pressure between 25 and 1350 Pa (0.2 torr and 10 torr).
